(19) Europäisches Patentamt
European Patent Office
Office européen des brevets

(11) **EP 3 751 277 B1**

(12) **EUROPÄISCHE PATENTSCHRIFT**

(45) Veröffentlichungstag und Bekanntmachung des Hinweises auf die Patenterteilung:
**12.02.2025 Patentblatt 2025/07**

(21) Anmeldenummer: **20173835.8**

(22) Anmeldetag: **11.05.2020**

(51) Internationale Patentklassifikation (IPC):
*G01N 29/04* (2006.01)   *G01N 29/11* (2006.01)
*G01N 29/24* (2006.01)   *G01N 29/22* (2006.01)
*G01N 29/28* (2006.01)   *B06B 1/06* (2006.01)
*G01N 29/07* (2006.01)   *B06B 1/02* (2006.01)

(52) Gemeinsame Patentklassifikation (CPC):
**G01N 29/043; B06B 1/0648; G01N 29/07; G01N 29/11; G01N 29/223; G01N 29/245; G01N 29/2475; G01N 29/28;** B06B 1/0215; B06B 2201/55; B06B 2201/74; G01N 2291/0422; G01N 2291/2675; H10N 30/208

(54) **SYSTEM ZUR ZERSTÖRUNGSFREIEN ULTRASCHALLPRÜFUNG VON BAUTEILEN**

SYSTEM FOR NON-DESTRUCTIVE ULTRASONIC TESTING OF COMPONENTS

SYSTÈME D'INSPECTION NON DESTRUCTIVE ULTRASONORE DES COMPOSANTS

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **14.05.2019 DE 102019206997**

(43) Veröffentlichungstag der Anmeldung:
**16.12.2020 Patentblatt 2020/51**

(73) Patentinhaber: **Fraunhofer-Gesellschaft zur Förderung der angewandten Forschung e.V. 80686 München (DE)**

(72) Erfinder:
• **WEIHNACHT, Bianca**
  **01109 Dresden (DE)**
• **GAUL, Tobias**
  **01109 Dresden (DE)**
• **LIESKE, Uwe**
  **01109 Dresden (DE)**
• **SCHUBERT, Lars**
  **01109 Dresden (DE)**
• **KÖHLER, Bernd**
  **01109 Dresden (DE)**

(74) Vertreter: **Pfenning, Meinig & Partner mbB Patent- und Rechtsanwälte An der Frauenkirche 20 01067 Dresden (DE)**

(56) Entgegenhaltungen:
EP-A1- 3 267 208     EP-A2- 0 706 036
DE-A1- 10 104 610

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung betrifft ein System zur zerstörungsfreien Prüfung (ZfP) von Bauteilen. Es kann insbesondere zur Prüfung an großformatigen Bauteilen oder an schwer zugänglichen Orten vorteilhaft eingesetzt werden.

Die Prüfung von Schweißnähten wird bisher auch mit Manschettenlösungen mit Scherwellen durchgeführt. Für den Verbleib am Bauteil gibt es bisher keine fertige Technologie. Insbesondere im Offshore-Bereich zur Prüfung von Gründungsstrukturen können die Taucher aber nicht bei jeder Prüfung Manschetten von mehreren Metern Durchmesser anlegen. Deswegen wurde eine Sensormanschette entwickelt, in die spezielle piezoelektrische Scherwellenwandler einlaminiert werden. Das kann so erfolgen, dass eine wasserdichte Systemlösung erhalten wird, die dauerhaft am jeweiligen Prüfobjekt (auch Unterwasser) verbleiben kann.

Die Überwachung von Offshore-Gründungsstrukturen erfolgt derzeit mittels Sichtprüfung durch Taucher. Dabei muss jede Anlage alle vier Jahre visuell oder mit zugelassenen zerstörungsfreien Prüfverfahren inspiziert werden. Insbesondere durch Bewuchs ist es bei der visuellen Prüfung recht schwer, feine Risse verlässlich detektieren zu können. Bisher ist zur zerstörungsfreien Prüfung nur Sichtprüfung und das Verfahren Alternating Current Focusing Technique (ACFM) zugelassen. Bei ACFM wird eine magnetische Rissprüfung durch Taucher vorgenommen. Die Methode ist zeitlich sehr aufwendig, da der Spulensensor manuell über alle Schweißnähte geführt werden muss. Eine Interpretation der so erhaltenen Messwerte ist nur durch Fachpersonal möglich und kann von den Tauchern nicht vorgenommen werden. Spitze Kehlnähte sind auf Grund ihrer Geometrie von einer Prüfung ausgeschlossen. Wurzellagen können aufgrund ihrer Lage im inneren des Rohres mit den zuvor genannten ZfP-Verfahren nicht geprüft werden. Remote Operated Vehicles (ROV) haben sich in den letzten Jahren rasant entwickelt und sind heute für die Inspektion von Unterwassertragstrukturen insbesondere in der Öl- und Gasindustrie Stand der Technik. Für Offshore-Windanlagen entwickelt sich der Markt erst langsam. ROV werden für eine klassische ZfP-Prüfung eingesetzt, um z.B. Schweißnähte zu inspizieren. Dafür wird die zu untersuchende Stelle gereinigt (Sandstrahlen, Bürsten und/oder Hochdruckreinigen) und anschließend, z.B. visuell, mit Ultraschallmesstechnik oder ACFM geprüft. Für die beiden letzten Verfahren muss der Sensorkopf direkt auf der zu untersuchenden Stelle aufgesetzt werden, was insbesondere in Kehlnähten nicht möglich ist. Die große Anzahl an erforderlichen Messstellen führt zu einer langen Prüfzeit.

Für Rohrleitungs- und eine Behälterprüfung gibt es ebenfalls konkrete Anforderungen an die Prüfung. In der Regel variieren diese von Branche zu Branche und werden im Rahmen von Revisionen durchgeführt. Durch eine kontinuierliche Monitoring-Lösung könnten teure Revisionen (z.B. ca. 1 Mio. € je Tag im Kohlekraftwerk) durch eine Datenerfassung und Prüfung im Betrieb ersetzt werden.

Für ZfP-Messungen stehen eine Reihe von Scherwellenprüfungssysteme zur Verfügung, die aber derzeit nicht für ein dauerhaftes Monitoring (Messsystem verbleibt am Bauteil) angewendet werden können. Es handelt sich um Sensormanschetten mit Scherwellenwandlern, die allerdings nicht für den Verbleib am Prüfobjekt als Structural Health Monitoring (SHM) -Lösung (Zustandsüberwachung) konzipiert wurden und deshalb auch nicht dafür geeignet sind. Durch den Verbleib an der zu untersuchenden Struktur kann eine wiederkehrende Prüfung entfallen.

So ist in DE 101 04 610 A1 eine Ultraschall-Sensoranordnung für horizontal polarisierte Transversalwellen beschrieben.

Es ist daher Aufgabe der Erfindung, Möglichkeiten für die zerstörungsfreie Prüfung von Bauteilen anzugeben, mit denen eine Prüfung auf Defekte unter schwierigen Bedingungen, mit ausreichender Messgenauigkeit und ggf. auch dauerhaft erreichbar ist.

Erfindungsgemäß wird diese Aufgabe mit einem System, das die Merkmale des Anspruchs 1 aufweist, gelöst. Vorteilhafte Ausgestaltungen und Weiterbildungen der Erfindung können mit in untergeordneten Ansprüchen bezeichneten Merkmalen realisiert werden.

Bei dem System sind zwei Ultraschall-Wandler, die ein Paar bilden und mit jeweils einem piezoelektrischem keramischen plattenförmigen Element mit rechteckiger Geometrie, die an zwei gegenüberliegenden Oberflächen jeweils mit einer Elektrode gebildet sind, an einer Oberfläche eines Bauteils befestigbar.

Die Ultraschallwandler des Paares sind in einem Abstand zueinander so angeordnet, dass kein direkter mechanischer Kontakt besteht. Die Ultraschall-Wandler des Paares können erfindungsgemäß nebeneinander mit paralleler Ausrichtung ihrer mittleren Längsachsen angeordnet sein, wobei die mittleren Längsachsen entlang einer gemeinsamen Achse ausgerichtet sein sollten.

Die beiden piezoelektrischen keramischen plattenförmigen Elemente weisen in einer Alternative eine unterschiedliche Polarisation entlang ihrer Breite b auf. Dabei sind die beiden Ultraschall-Wandler des Paares mit gleicher Polung an eine gepulst betreibbare elektrische Spannungsquelle angeschlossen.

Bei einer zweiten Alternative weisen die beiden piezoelektrischen keramischen plattenförmigen Elemente eine gleiche Polarisation entlang ihrer Breite b auf. Dabei sind beiden Ultraschall-Wandler des Paares mit entgegengesetzter Polung an eine gepulst betreibbare elektrische Spannungsquelle angeschlossen.

Dabei soll unter Breite b die längere Kantenlänge einer Seite der piezoelektrischen keramischen plattenförmigen Elemente verstanden sein.

Die elektrische Spannungsquelle ist ausgebildet, elektrische Spannungen im Frequenzbereich von 10 kHz bis 1 MHz an die beiden Ultraschall-Wandler anzulegen.

Mindestens einer der beiden Ultraschall-Wandler des Paares oder mindestens ein weiterer in einem bekannten Abstand zu den beiden Ultraschall-Wandlern angeordneter weiterer Ultraschall-Wandler ist/sind ausgebildet von Defekten am Bauteil reflektierte Ultraschallwellen und/oder von den beiden Ultraschall-Wandlern des Paares gleichzeitig emittierte Scherwellen zu detektieren und die detektierten Ultraschallwellen an eine elektronische Auswerte- und Steuereinheit zu übertragen. Dabei ist die elektronische Auswerteeinheit ausgebildet, die detektierten Ultraschallwellen bezüglich ihrer Amplitude und/oder ihres zeitlichen Ablaufs auszuwerten.

Mit der Erfindung können neuartige Scherwellenwandler zur Prüfung von Strukturen mit geführten Scherwellen zur Verfügung gestellt werden, die im Gegensatz zu bekannten Lösungen folgende Möglichkeiten bieten. So ist eine preiswerte und auch automatisierbare Herstellung möglich. Es ergibt sich ein Potenzial für Langzeit-Monitoring-Technologien.

Mit entsprechend ausgebildeten und angeordneten Ultraschall-Wandlern können höhere Amplituden der emittierten geführten Scherwellen erreicht werden, was zu einer verbesserten Effizienz und einer Erweiterung des möglichen Einsatzspektrums führt.

Die Ultraschall-Wandler des Paares können sehr flach ausgebildet werden. Die maximale Dicke der piezoelektrischen keramischen plattenförmigen Elemente ($d_p$) kann $\leq$ 1 mm gehalten werden. Auch die einsetzbaren Elektroden erhöhen die Gesamtdicke nur unwesentlich. Durch die kleine Dicke des keramischen Materials kann eine Anpassung an die jeweilige Bauteiloberfläche durch elastisches Biegen erreicht werden, so dass die Ultraschall-Wandler des Paares auch bei nicht ebenen Oberflächen flächig anliegen können und dadurch eine effizientere Einkopplung der emittierten Scherwellen in das Bauteil entlang seiner Oberfläche als geführte Scherwellen möglich wird.

Das Verhältnis zwischen Breite b und Länge I der piezoelektrischen keramischen plattenförmigen Elemente b zu I sollte mindestens 3 zu 1 betragen.

Der Mittelpunkt- oder Flächenschwerpunktabstand der piezoelektrischen keramischen plattenförmigen Elemente der Ultraschall-Wandler des Paares sollte ein ungerades ganzzahliges Vielfaches der halben Wellenlänge λ der emittierten Ultraschallwellen betragen.

Bei der Aktivierung der beiden Ultraschall-Wandler eines Paares werden Scherwellen in die Richtung senkrecht zur mittleren Längsachse der Ultraschall-Wandler emittiert. In diese Richtung breiten sie sich divergent aus.

Die bei der Erfindung eingesetzten Ultraschall-Wandler eignen sich auf Grund der geringen Bauteilhöhe, die allerdings trotzdem ausreichend hohe Amplituden generieren, um auch in mehreren Metern Abstand noch prüfen zu können. Ein grundsätzlicher Vorteil ist der geringe Bauraumbedarf und die Flexibilität. Dies eröffnet die Möglichkeit, Netze mit vielen verteilten Ultraschall-Wandlern auf der Bauteiloberfläche zu applizieren, ohne an dieser bauliche Veränderungen durchführen zu müssen. Es können auch mehr als ein Paar an Ultraschall-Wandlern für die Emission der Scherwellen Bestandteil des Systems sein.

Mit der Erfindung kann außerdem eine Nachrüstung bestehender Bauteile ermöglicht werden, was beispielsweise im Einsatz bei unerwartet auftretenden Schwachstellen oder Fehlerhäufungen von großem Vorteil ist. Ebenso ist die Zusammenfassung einer größeren Zahl an derartigen Sensoren und Aktoren zu komplexen Netzwerken vorteilhaft.

Mittels der Ultraschall-Wandlerpaare überlagert sich deren Wirkung während der Emission, so dass die Amplituden der emittierten Scherwellen erhöht werden können, ohne aufwendige elektronische Einzelbeschaltung der einzelnen Wandler. Der Abstand zwischen den zwei Ultraschall-Wandlern sollte dabei derart gewählt sein, dass zwischen ihnen keine direkte Kraftübertragung stattfinden kann.

Der Vorteil dieser Erfindung besteht darin, dass ZfP-Methoden nun kostengünstig als Monitoring angewendet werden können. Dadurch erhöht sich die Sicherheit der untersuchten Bauteile.

Die Ultraschall-Wandler können mittels eines elastisch verformbaren Materials an der Bauteiloberfläche fixiert werden.

Dazu können die Ultraschall-Wandler in ein elastisch verformbares Material eingebettet oder einlaminiert werden. Die Ultraschall-Wandler können mit elastisch verformbarem Material in Form einer Manschette am jeweiligen Bauteil befestigt werden, die z.B. im Offshore-Bereich weniger Wellenwiderstand bewirkt, wenn sie permanent an der jeweiligen Struktur angebracht ist. Weiterhin finden sie auch Platz unter Isolationen/Abdeckungen/Einhausungen für eine Rohrleitungsüberwachung, ohne dass eine Anpassung der Geometrie erforderlich wird.

Die Erfindung kann beispielsweise bei der Offshore-Überwachung von Unterwasserschweißnahten (Rissdetektion), der Rohrleitungsüberwachung (Rissdetektion, auch unterhalb einer Isolation/Abdeckung/Einhausung, bei einer Behälterüberwachung auf Risse und Korrosion, auch unterhalb einer Isolation/Abdeckung/Einhausung eingesetzt werden.

Bei der Anwendung des Systems können entweder Impuls-Echo Messungen mit mindestens einem Paar von Ultraschall-Wandlern durchgeführt, oder Sende-Empfangsmessungen zwischen mindestens einem Paar von Ultraschall-Wandlern und einem weiteren Ultraschall-Wandler, der in einem bekannten Abstand zu dem jeweiligen Paar angeordnet ist, durchgeführt werden. Zur Ermittlung eines Schadens können die an einer Fehlstelle gestreuten Wellenanteile in Reflexion oder Transmission detektiert und ausgewertet werden.

Für die Emission von Scherwellen werden zumeist kurze Burst Signale verwendet die eine zeitlich begrenzte Länge haben und ein relativ enges Frequenzspektrum aufweisen. Die zeitliche Länge sollte im Bereich 5 µs bis 1 ms gehalten werden. In den Pausen dazwischen, in denen keine Scherwellen emittiert werden, kann eine Detektion erfolgen.

Nachfolgend soll die Erfindung beispielhaft näher erläutert werden. Dabei können Merkmale unabhängig vom jeweiligen Beispiel oder der jeweiligen Darstellung miteinander kombiniert werden.

Dabei zeigen:

Figur 1 ein Beispiel eines Paares von Ultraschall-Wandlern, die bei der Erfindung einsetzbar sind in zwei Ansichten;

Figur 2 ein weiteres Beispiel eines Paares von Ultraschall-Wandlern, die bei der Erfindung einsetzbar sind in zwei Ansichten; Figur 3 die Wirkrichtung emittierter Scherwellen (Draufsicht);

Figur 4 ein Beispiel für Sendefunktionen, die als breitbandiges Sendesignal (Sinc, oben) oder als bandbreitenbegrenztes Sendesignal (RC4) ausgeführt werden können;

Figur 5 ein Diagramm der frequenzabhängigen erreichbaren Schwinggeschwindigkeit des SH0-Modes im Vergleich; Anregung durch einfachen Ultraschall-Wandler 40 mm x 10 mm (schwarze Kurve) vs. zwei ein Paar bildender Ultraschall-Wandler (graue Kurve), wie sie bei der Erfindung einsetzbar sind 40 mm x 5 mm (x2). (aufgezeichnet mittels Laservibrometrie in einer Entfernung von 200 mm vom Mittelpunkt der Ultraschallwandler, und

Figur 6 ein typisches Phasengeschwindigkeitsdiagramm der Scherwellenmoden für den Werkstoff Stahl

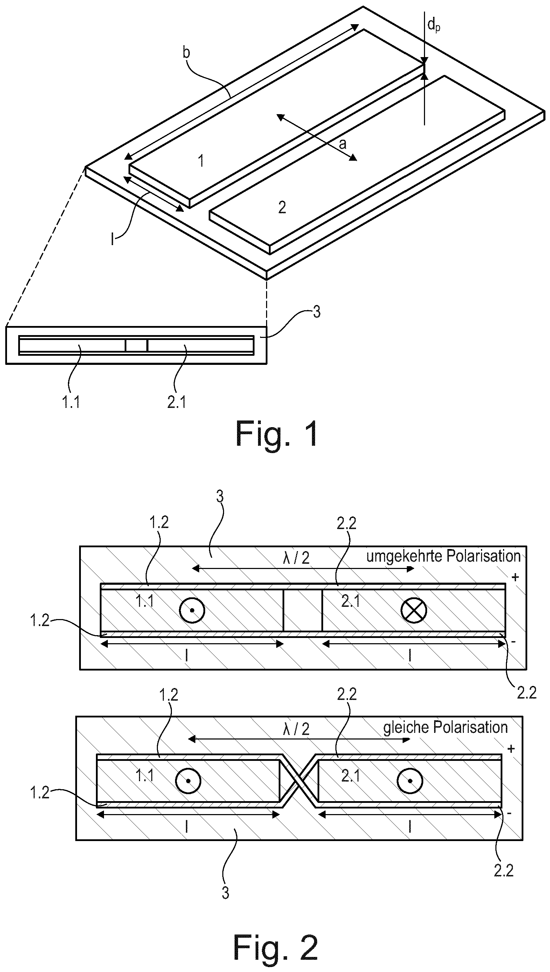

In Figur 1 sind eine Schnittdarstellung und eine perspektivische Darstellung eines Beispiels zweier Ultraschallwandler 1 und 2 gezeigt, die nebeneinander angeordnet sind. Dabei sind ihre mittleren Längsachsen parallel zueinander ausgerichtet, wobei die beiden mittleren Längsachsen jeweils auch parallel zu den Kanten mit der Länge b ausgerichtet sind. Die beiden Ultraschall-Wandler 1 und 2 bilden ein Paar.

Wie man insbesondere Figur 2 entnehmen kann, sind an den zwei gegenüberliegenden Oberflächen der piezoelektrischen keramischen Elemente 1.1 und 2.1 jeweils eine Elektrode 1.2 und 2.2 vorhanden, die an eine mit einer nicht gezeigten elektrischen Spannungsquelle angeschlossen sind. Die elektrische Spannungsquelle kann direkt oder über einen Frequenzgenerator gepulst betrieben und von einer ebenfalls nicht gezeigten elektronischen Auswerte- und Steuereinheit angesteuert werden. So können die elektrische Leistung und die Frequenz, mit denen Scherwellen emittiert werden, definiert beeinflusst werden.

Der Abstand a der Flächenschwerpunkte der zwei piezoelektrischen keramischen plattenförmigen Elemente 1.1 und 2.1 ist so gewählt, wie er im allgemeinen Teil der Beschreibung erwähnt worden ist. Der Abstand a ist so gewählt, dass kein direkter berührender mechanischer Kontakt besteht, so dass sie sich während ihres Betriebes nicht direkt mechanisch beeinflussen.

Die eigentliche Detektion von Defekten kann so erfolgen, wie es im allgemeinen Teil der Beschreibung beschrieben worden oder aus dem Stand der Technik prinzipiell bekannt ist.

Die zwei Ultraschall-Wandler 1 und 2, die ein Paar bilden, können in ein elastisch verformbares Material 3 einlaminiert werden.

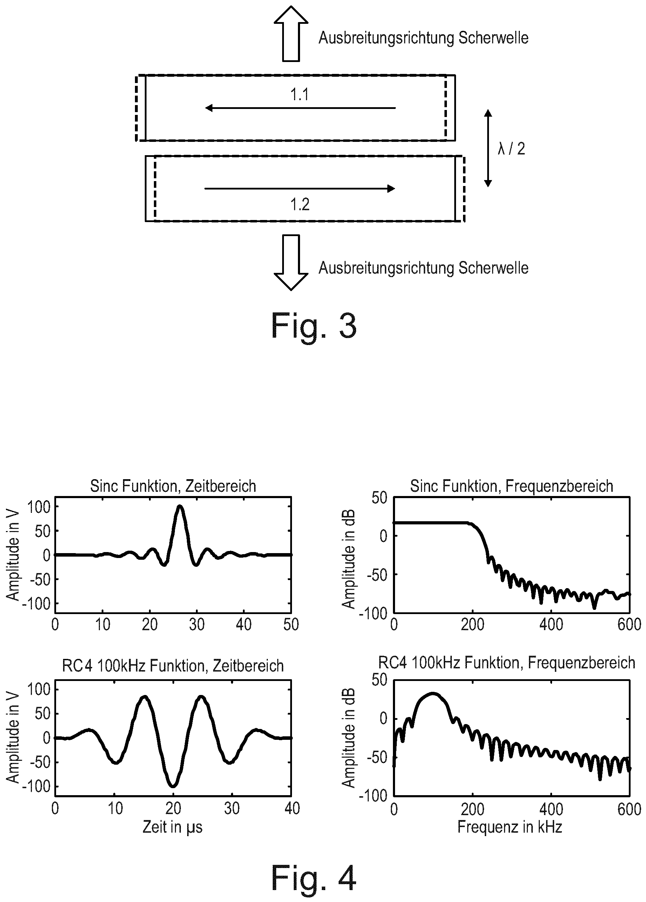

Den in Figur 4 gezeigten Diagrammen für emittierte Scherwellen, die als breitbandiges Sendesignal (Sinc-Funktion, gefenstert) oder als bandbreitenbegrenztes Sendesignal (RC4) bezeichnet sind, kann man die erfassbaren Amplituden zeitaufgelöst bzw. in Abhängigkeit der jeweiligen Frequenz entnehmen. Dabei handelt es sich um ein breitbandiges Sendesignal bis 200 kHz (Sinc) und ein bandbegrenztes Sendesignal (RC4 bei 100 kHz).

Die Geschwindigkeit von Scherwellen ist wie folgt definiert:

$$c(\omega) = \frac{c_s}{\sqrt{1 - (\eta d)^2 \left(\frac{c_s}{\omega d}\right)^2}}$$

$$c_s = \sqrt{\frac{G}{\rho}}$$

mit $G$ ⋯ *Schubmodul,* $\rho$ ... Dichte

$$\omega = 2\pi f$$

$$\eta d = k\frac{\pi}{2}, k = 0,1,2,3,...$$

$d$ ⋯ *halbe Strukturdicke*
$f$ ⋯ *Frequenz*

Dabei beschreibt k die Ordnung der Wellenmode (SH0, SH1, SH2, ...) Bei der fundamentalen Scherwellenmode (k=0) reduziert sich die Formel auf die reine Transversalwellengeschwindigkeit. Die Wellenlänge lässt sich aus der bekannten Ausbreitungsgeschwindigkeit $c_s$ und der Frequenz f des Sendesignals berechnen.

$$\lambda = \frac{c_s}{f}$$

Labormessungen zeigen, dass die Effizienz der zwei Ultraschall-Wandler 1 und 2 durch die zwei entgegengesetzten piezoelektrischen keramischen plattenförmigen Elemente 1.1 und 2.1 gegenüber einer einfachen Anordnung erhöht werden können, d.h. der Anteil an Energie der in die beabsichtigte Ausbreitungsrichtung der emittierten Scherwellen steigt bei gleichem Volumen an piezoelektrischem keramischen Material.

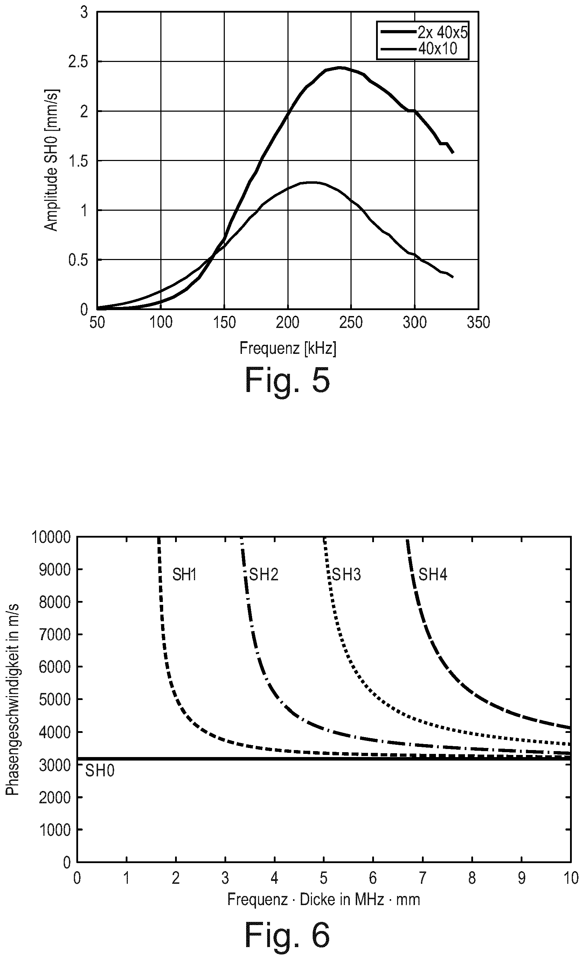

Dem in Figur 5 gezeigten Diagramm kann man die frequenzabhängigen erreichbaren Amplituden im Vergleich einfacher Ultraschall-Wandler 40 mm x 10mm (schwarzer Kurvenverlauf) im Vergleich zu den mit zwei ein Paar bildenden Ultraschall-Wandlern, wie sie bei der Erfindung einsetzbar sind 40mm x 5mm (x2) (grauer Kurvenverlauf) entnehmen.

**Patentansprüche**

1. System zur zerstörungsfreien Prüfung von Bauteilen, bei dem zwei ein Paar bildende Ultraschall-Wandler (1, 2) die mit jeweils einem piezoelektrischem keramischen plattenförmigen Element (1.1, 2.1) mit rechteckiger Geometrie, die an zwei gegenüberliegenden Oberflächen jeweils mit einer Elektrode (1.2, 2.2) gebildet sind, an einer Oberfläche eines Bauteils befestigbar sind, wobei

   die zwei Ultraschallwandler (1, 2) des Paares in einem Abstand zueinander so angeordnet sind, so dass kein direkter mechanischer Kontakt besteht und die zwei Ultraschall-Wandler (1, 2) des Paares nebeneinander mit paralleler Ausrichtung ihrer mittleren Längsachsen angeordnet sind, wobei die mittleren Längsachsen jeweils auch parallel zu Kanten der piezoelektrischen keramischen plattenförmigen Elemente (1.1, 2.1) mit einer Breite b sind, und
   die beiden piezoelektrischen keramischen plattenförmigen Elemente (1.1, 2.1) eine unterschiedliche Polarisation entlang ihrer Breite b aufweisen, wobei die Breite b einer längeren Kantenlänge der rechteckigen Geometrie der piezoelektrischen keramischen plattenförmigen Elemente (1.1, 2.1) entspricht, und dabei die beiden Ultraschall-Wandler (1, 2) des Paares mit gleicher Polung an eine gepulst betreibbare elektrische Spannungsquelle des Systems angeschlossen sind oder
   die beiden piezoelektrischen keramischen plattenförmigen Elemente (1.1, 2.1) eine gleiche Polarisation entlang ihrer Breite b aufweisen und dabei die beiden Ultraschall-Wandler (1, 2) des Paares mit entgegengesetzter Polung an eine gepulst betreibbare elektrische Spannungsquelle des Systems angeschlossen sind und

   die elektrische Spannungsquelle ausgebildet ist, elektrische Spannungen im Frequenzbereich von 10 kHz bis 1 MHz an die beiden Ultraschall-Wandler (1, 2) anzulegen und mindestens einer der beiden Ultraschall-Wandler (1, 2) des Paares und/oder mindestens ein weiterer in einem bekannten Abstand zu den beiden Ultraschall-Wandlern (1, 2) des Paares angeordneter weiterer Ultraschall-Wandler des Systems ausgebildet ist/sind von Defekten am Bauteil reflektierte Ultraschallwellen und/oder von den beiden Ultraschall-Wandlern (1, 2) des Paares gleichzeitig emittierten Scherwellen zu detektieren und die detektierten Ultraschallwellen an eine elektronische Auswerte- und Steuereinheit des Systems übertragbar sind, wobei die elektronische Auswerteeinheit ausgebildet ist, die detektierten Ultraschallwellen bezüglich ihrer Amplitude und/oder ihres zeitlichen Ablaufs auszuwerten.

2. System nach Anspruch 1, **dadurch gekennzeichnet, dass** der Mittelpunkt- oder Flächenschwerpunktabstand der piezoelektrischen keramischen plattenförmigen Elemente (1.1, 2.1) der Ultraschall-Wandler (1, 2) des Paares ein ungerades ganzzahliges Vielfaches der halben Wellenlänge der emittierten Ultraschallwellen beträgt.

3. System nach einem der vorhergehenden Ansprüche, **dadurch gekennzeichnet, dass** ein Verhältnis zwischen Breite b und Länge l der piezoelektrischen keramischen plattenförmigen Elemente (1.1, 2.1) von mindestens 3 zu 1 eingehalten ist.

4. System nach einem der vorhergehenden Ansprüche, **dadurch gekennzeichnet, dass** die piezoelektrischen keramischen plattenförmigen Elemente (1.1, 2.1) eine maximale Dicke $d_p$ von 1 mm aufweisen.

5. System nach einem der vorhergehenden Ansprüche, **dadurch gekennzeichnet, dass** die Ultraschall-Wandler (1, 2) des Paares des Systems mittels eines elastisch verformbaren Materials (3) am jeweiligen Bauteil befestigbar sind.

6. System nach einem der vorhergehenden Ansprüche, **dadurch gekennzeichnet, dass** die mindestens zwei Ultraschall-Wandler (1, 2) des Paares des Systems in einem elastisch verformbaren Material (3) eingebettet oder darin einlaminiert sind.

7. System nach einem der zwei vorhergehenden Ansprüche, **dadurch gekennzeichnet, dass** mit dem elastisch verformbaren Material (3) eine Manschette des Systems gebildet ist, mit der die Ultraschall-Wandler (1, 2) des Paares an der Oberfläche des jeweiligen Bauteils so befestigbar sind, dass die Ultraschall-Wandler flächig an der jeweiligen Bauteiloberfläche anliegen.

## Claims

1. System for the non-destructive testing of components, in which two ultrasonic transducers (1, 2), which form a pair and each have a piezoelectric ceramic plate-shaped element (1.1, 2.1) with a rectangular geometry, which are formed on two opposite surfaces each with an electrode (1.2, 2.2), can be fastened to a surface of a component, wherein

   the two ultrasonic transducers (1, 2) in the pair are arranged at a distance from one another such that there is no direct mechanical contact and the two ultrasonic transducers (1, 2) in the pair are arranged beside one another with a parallel orientation of their central longitudinal axes, wherein each of the central longitudinal axes are also parallel to the edges of the piezoelectric ceramic plate-shaped elements (1.1, 2.1) having a width b, and
   the two piezoelectric ceramic plate-shaped elements (1.1, 2.1) have a different polarization along their width b, wherein the width b corresponds to a longer edge length of the rectangular geometry of the piezoelectric ceramic plate-shaped elements (1.1, 2.1) and the two ultrasonic transducers (1, 2) in the pair are connected in this case with the same polarity to an electrical voltage source which can be operated in a pulsed manner,
   or
   the two piezoelectric ceramic plate-shaped elements (1.1, 2.1) have an identical polarization along their width b, and the two ultrasonic transducers (1, 2) in the pair are connected in this case with opposite polarity to an electrical voltage source which can be operated in a pulsed manner, and
   the electrical voltage source is designed to apply electrical voltages in the frequency range of 10 kHz to 1 MHz to the two ultrasonic transducers (1, 2), and
   at least one of the two ultrasonic transducers (1, 2) in the pair and/or at least one further ultrasonic transducer arranged at a known distance from the two ultrasonic transducers (1, 2) in the pair is/are designed to detect ultrasonic waves reflected by defects on the component and/or shear waves simultaneously emitted by the two ultrasonic transducers (1, 2) in the pair, and the detected ultrasonic waves can be transmitted to an electronic evaluation and control unit, wherein the electronic evaluation unit is designed to evaluate the detected ultrasonic waves with respect to their amplitude and/or their temporal sequence.

2. System according to Claim 1, **characterized in that** the centre or area centroid spacing of the piezoelectric ceramic plate-shaped elements (1.1, 2.1) of the ultrasonic transducers (1, 2) in the pair is an odd integer multiple of half the wavelength of the emitted ultrasonic waves.

3. System according to one of the preceding claims, **characterized in that** the ratio of width b to length l of the piezoelectric ceramic plate-shaped elements (1.1, 2.1) of at least 3 to 1 is complied with.

4. System according to one of the preceding claims, **characterized in that** the piezoelectric ceramic plate-shaped elements (1.1, 2.1) have a maximum thickness $d_p$ of 1 mm.

5. System according to one of the preceding claims, **characterized in that** the ultrasonic transducers (1, 2) in the pair can be fastened to the respective component by means of an elastically deformable material (3).

6. System according to one of the preceding claims, **characterized in that** the at least two ultrasonic transducers (1, 2) in the pair are embedded or laminated in an elastically deformable material (3).

7. System according to one of the preceding claims, **characterized in that** a sleeve is formed with the elastically deformable material (3) and can be used to fasten the ultrasonic transducers (1, 2) in the pair to the surface of the respective component such that the ultrasonic transducers rest on the respective component surface in a flat manner.

## Revendications

1. Système d'inspection non destructive de composants, dans lequel deux transducteurs à ultrasons (1, 2) qui forment une paire et sont constitués de respectivement un élément céramique piézoélectrique en forme de plaque (1.1, 2.1) à géométrie rectangulaire, lesdits éléments étant constitués de respectivement une électrode (1.2, 2.2) au niveau de deux surfaces opposées, peuvent être fixés à la surface d'un composant, dans lequel

   les deux transducteurs à ultrasons (1, 2) de la paire sont agencés à distance l'un de l'autre de sorte qu'il n'y ait pas de contact mécanique direct et que les deux transducteurs à ultrasons (1, 2) de la paire soient agencés l'un à côté de l'autre avec une orientation parallèle de leurs axes longitudinaux centraux, dans lequel les axes longitudinaux centraux sont également parallèles aux bords, de largeur b, des éléments céramiques piézoélectriques en forme de plaque (1.1, 2.1), et

les deux éléments céramique piézoélectrique en forme de plaque (1.1, 2.1) présentent une polarisation différente le long de leur largeur b, dans lequel la largeur b correspond à la plus grande longueur de bord de la géométrie rectangulaire des éléments céramiques piézoélectriques en forme de plaque (1.1, 2.1), et les deux transducteurs à ultrasons (1, 2) de la paire sont connectés avec la même polarité à une source de tension électrique à fonctionnement pulsé du système

ou

les deux éléments céramiques piézoélectriques en forme de plaque (1.1, 2.1) présentent la même polarisation le long de leur largeur b et les deux transducteurs à ultrasons (1, 2) de la paire sont connectés avec une polarité opposée à une source de tension électrique à fonctionnement pulsé du système et

la source de tension électrique est conçue pour appliquer aux deux transducteurs à ultrasons (1, 2) des tensions électriques situées dans la plage de fréquences comprises entre 10 kHz et 1 MHz et

au moins un des deux transducteurs à ultrasons (1, 2) de la paire et/ou au moins un autre transducteur à ultrasons du système, agencé à une distance connue des deux transducteurs à ultrasons (1, 2) de la paire, est/sont conçu(s) pour détecter les ondes ultrasonores réfléchies par des défauts du composant et/ou des ondes de cisaillement émises simultanément par les deux transducteurs à ultrasons (1, 2) de la paire, et les ondes ultrasonores détectées peuvent être transmises à une unité d'évaluation et de commande électronique du système, dans lequel l'unité d'évaluation électronique est conçue pour évaluer les ondes ultrasonores détectées quant à leur amplitude et/ou leur évolution temporelle.

2. Système selon la revendication 1, **caractérisé en ce que** la distance par rapport au centre ou au centre de gravité des éléments céramiques piézoélectriques en forme de plaque (1.1, 2.1) des transducteurs à ultrasons (1, 2) de la paire est un multiple entier impair de la moitié de la longueur d'onde des ondes ultrasonores émises.

3. Système selon l'une quelconque des revendications précédentes, **caractérisé en ce qu'**un rapport entre la largeur b et la longueur l des éléments céramiques piézoélectriques en forme de plaque (1.1, 2.1) compris entre au moins 3 et 1 est respecté.

4. Système selon l'une quelconque des revendications précédentes, **caractérisé en ce que** les éléments céramiques piézoélectriques en forme de plaque (1.1, 2.1) présentent une épaisseur maximale $d_p$ égale à 1 mm.

5. Système selon l'une quelconque des revendications précédentes, **caractérisé en ce que** les transducteurs à ultrasons (1, 2) de la paire du système peuvent être fixés au composant respectif au moyen d'un matériau (3) élastiquement déformable.

6. Système selon l'une quelconque des revendications précédentes, **caractérisé en ce que** les au moins deux transducteurs à ultrasons (1, 2) de la paire du système sont intégrés ou stratifiés dans un matériau (3) élastiquement déformable.

7. Système selon l'une quelconque des deux revendications précédentes, **caractérisé en ce qu'**avec le matériau élastiquement déformable (3) est formé un manchon du système, grâce auquel les transducteurs à ultrasons (1, 2) de la paire peuvent être fixés à la surface du composant respectif de sorte que les transducteurs à ultrasons reposent à plat contre la surface respective de composant.

Fig. 1

Fig. 2

Fig. 3

Fig. 4

Fig. 5

Fig. 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10104610 A1